# EUROPEAN PATENT APPLICATION

(11) **EP 4 261 329 A1**
(43) Date of publication of application: **18.10.2023**
(21) Application number: 21902924.6
(22) Date of filing: 14.07.2021
(51) Int. Cl.: C25D 3/46, C25D 3/64, C25D 5/10, C25D 5/12

(54) **AG-COATED MATERIAL, AG-COATED MATERIAL MANUFACTURING METHOD, AND TERMINAL COMPONENT**

(30) Priority: 10.12.2020 JP 2020204658
(71) Applicant: Dowa Metaltech Co., Ltd., Tokyo 101-0021 (JP)
(72) Inventor: SATO, Yosuke, Tokyo 101-0021 (JP); HIRAI, Yutaro, Tokyo 101-0021 (JP); ARAI, Kentaro, Tokyo 101-00021 (JP)
(74) Representative: Müller-Boré & Partner Patentanwälte PartG mbB
(86) International application number: PCT/JP2021/026418
(87) International publication number: WO 2022/123818

(57) **Abstract**

There is provided an Ag-coated material and its related technique, including a base material and an Ag film on the base material, the Ag film including alternately laminated at least three Ag layers with average crystal grain sizes different by three times or more.

## Description

### Background

### Technical Field

The present invention relates to an Ag-coated material, a method for producing the same, and the like, and particularly, relates to an Ag-coated material used as a material for contacts and terminal components of connectors, switches, relays, etc. used in electric wiring for automobiles and households, and a method for producing the same.

### Description of Related Art

Conventionally, a plated material is obtained by plating a base material with tin, silver, gold, etc., depending on required properties such as electrical properties and solderability, the base material being copper, copper alloy, and stainless steel that are relatively inexpensive and excellent in corrosion resistance and mechanical properties. The plated material is used as a material for contacts and terminal components of connectors and switches. A metal film formed by plating has excellent adhesion with a base material, and plating has an advantage of a low production cost.

A tin-plated material obtained by plating a base material such as copper, copper alloy, or stainless steel with tin is inexpensive, but has poor corrosion resistance in a high-temperature environment. Further, a gold-plated material obtained by plating these base materials with gold has excellent corrosion resistance and high reliability, but the cost of raw materials increases. On the other hand, a silver-plated material obtained by applying silver plating to these base materials is inexpensive compared to the gold-plated material and has excellent corrosion resistance compared to the tin-plated material.

Further, a material for contacts and terminal components of connectors and switches is required to have wear resistance due to insertion and removal of connectors and sliding of switches.

Patent document 1 discloses that due to an Ag-plated material with a surface layer plated with Ag and having {111} plane as a preferential orientation plane on the base material, an increase in contact resistance can be prevented while maintaining high hardness (wear resistance). Patent document 1 also discloses that it is preferable to form an underlying layer comprising nickel between the base material and the surface layer, and due to this underlying layer, the adhesion between the base material and the surface layer can be enhanced.

Further, in many cases, the Ag-plated material is punched out into a predetermined shape by press work and bent into a product shape. However, during this bending process, cracks occur and the material breaks, or cracks occur to expose the base material resulting in material corrosion, and a product life is significantly shortened in some cases.

Regarding such bending workability, Patent document 2 describes as follows: in a silver-plated material in which a surface layer comprising silver is formed on the surface of the base material comprising copper or copper alloy, or on the surface of an underlying layer comprising copper or copper alloy formed on the base material, the ratio of an X-ray diffraction intensity on {200} plane to the sum of the X-ray diffraction intensity on each of {111} plane, {200} plane, {220} plane, and {311} plane of the surface layer is 40% or more. Patent document 2 also describes that this silver-plated material has good bending workability and can suppress an increase in contact resistance even when used in a high-temperature environment.

Patent document 3 describes a silver-plated laminate that is a laminate of a metal substrate and a silver-plated layer, wherein the silver-plated layer includes: a soft silver-plated layer formed on the surface of the metal substrate and a hard silver-plated layer formed on the surface of the soft silver-plated layer, wherein a Vickers hardness of the soft silver-plated layer is lower than a Vickers hardness of the hard silver-plated layer by 30 HV or more, and also discloses that this silver-plated laminate achieves both excellent wear resistance and workability.

Patent document 4 discloses that a contact portion of a contact has a substrate comprising copper or copper alloy, a second plated layer formed on the substrate, and a first plated layer formed on the second plated layer, in which the first plated layer comprises silver or silver alloy and has a Vickers hardness of 90 Hv or less, and the second plated layer comprises silver or silver alloy and has a Vickers hardness of 100 Hv or more. Patent document 4 also discloses that a connector with such a contact has a low contact resistance.

### Prior Art Document

### Patent Document

[Patent Document 1] JP-A-2015-110833
[Patent Document 2] JP-A-2013-76127
[Patent Document 3] JP-A-2014-95139
[Patent Document 4] JP-A-2016-15224

### Summary of the Invention

### Problem to be solved by the Invention

As described above, materials such as contacts and terminal components are required to have properties such as wear resistance and bending workability.

In recent years, the need for electric vehicles such as EVs (Electric Vehicles) and PHVs (Plug-in Hybrid Vehicles) has increased due to a problem with environmental regulations, and as materials for contacts and terminal components of electric vehicles, a wrought copper material, etc., covered with a layer of silver is often used as a substrate from a viewpoint of conductivity and contact reliability.

For electric vehicles, excellent heat-resistant adhesion is required between the base material and the silver layer, or between the underlying Ni layer and the silver layer, in consideration of a usage environment (generating Joule heat due to energization, etc.). Specifically, after the connectors on which the silver layer is formed are heated in a state of contact (fitting), there is a problem of preventing peeling between the base material and the silver layer or between the nickel layer and the silver layer when separating the two layers.

None of the configurations disclosed in Patent documents 1 to 4 exhibits sufficient heat-resistant adhesion, and the configurations disclosed in Patent documents 1 and 4 do not exhibit sufficient bending workability.

Accordingly, an object of the present invention is to provide a silver-coated material excellent in heat-resistant adhesion and bending workability and a method for producing the same.

### Means for solving the Problem

According to a first aspect of the present invention, there is provided an Ag-coated material, including a base material and an Ag film on the base material, the Ag film including alternately laminated at least three Ag layers with average crystal grain sizes different by three times or more.

According to a second aspect of the present invention, there is provided the Ag-coated material according to the first aspect, wherein the Ag film includes Ag layers of four or more lamination.

According to a third aspect of the present invention, there is provided the Ag-coated material according to the first or second aspect, wherein the Ag film includes Ag layers of alternately laminated Ag layer 1 comprising Ag with a small average crystal grain size and Ag layer 2 comprising Ag with a larger average crystal grain size than the Ag layer 1, from a side closer to the base material.

According to a fourth aspect of the present invention, there is provided the Ag-coated material according to the third aspect, wherein an average crystal grain size (area average grain size) of the Ag layer 1 is 0.2 µm or less.

According to a fifth aspect of the present invention, there is provided the Ag-coated material according to the third or fourth aspect, wherein an average crystal grain size (area average grain size) of the Ag layer 2 is 0.3 µm or more.

According to a sixth aspect of the present invention, there is provided the Ag-coated material according to any one of the third to fifth aspects, wherein the Ag layer 1 has a thickness of 0.5 to 5 µm.

According to a seventh aspect of the present invention, there is provided the Ag-coated material according to any one of the third to sixth aspects, wherein the Ag layer 2 has a thickness of 0.5 to 5 µm.

According to an eighth aspect of the present invention, there is provided the Ag-coated material according to any one of the third to seventh aspects, wherein a preferential orientation plane of the Ag layer 1 is {111} plane, and a preferential orientation plane of the Ag layer 2 is {100} plane.

According to a nineth aspect of the present invention, there is provided the Ag-coated material according to any one of the third to eighth aspects, wherein an outermost layer of the Ag-coated material is the Ag layer 2.

According to a tenth aspect of the present invention, there is provided the Ag-coated material according to any one of the first to nineth aspects, wherein an underlying layer comprising Ni is provided between the base material and the Ag film.

According to an eleventh aspect of the present invention, there is provided the Ag-coated material according to any one of the first to tenth aspects, wherein the base material comprises Cu or Cu alloy.

According to a twelfth aspect of the present invention, there is provided the Ag-coated material according to any one of the first to eleventh aspects, wherein Vickers hardness HV of the Ag-coated material is 100 or more.

According to a thirteenth aspect of the present invention, there is provided a method for producing an Ag-coated material, including: forming an Ag film on a base material by alternately laminating at least three Ag layers with different average crystal grain sizes by three times or more.

According to a fourteenth aspect of the present invention, there is provided the method for producing an Ag-coated material according to the thirteenth aspect, wherein the Ag film is formed by laminating four or more Ag layers.

According to a fifteenth aspect of the present invention, there is provided the method for producing an Ag-coated material according to the fourteenth aspect, wherein Ag layer 1 comprising Ag with a small average crystal grain size and Ag layer 2 comprising Ag with a larger average crystal grain size than the Ag layer 1 are alternately formed on the base material.

According to a sixteenth aspect of the present invention, there is provided the method for producing an Ag-coated material according to the fifteenth aspect, wherein the Ag layer 1 has an average crystal grain size (area average grain size) of 0.2 µm or less.

According to a seventeenth aspect of the present invention, there is provided the method for producing an Ag-coated material according to the fifteenth or sixteenth aspect, wherein the Ag layer 2 has an average crystal grain size (area average grain size) of 0.3 µm or more.

According to an eighteenth aspect of the present invention, there is provided the method for producing an Ag-coated material according to any one of the fifteenth to the seventeenth aspects, wherein the Ag layer 1 has a thickness of 0.5 to 5 µm.

According to a nineteenth aspect of the present invention, there is provided the method for producing an Ag-coated material according to any one of the fifteenth to eighteenth aspects, wherein the Ag layer 2 has a thickness of 0.5 to 5 µm.

According to a twentieth aspect of the present invention, there is provided the method for producing an Ag-coated material according to any one of the fifteenth to nineteenth aspects, wherein
a preferential orientation plane of the Ag layer 1 is {111} plane, and a preferential orientation plane of the Ag layer 2 is {100} plane.

According to a twenty-first aspect of the present invention, there is provided the method for producing an Ag-coated material according to any one of the fifteenth to twentieth aspects, including:
forming the Ag layer 2 as an outermost layer of the Ag-coated material.

According to a twenty-second aspect of the present invention, there is provided the method for producing an Ag-coated material according to any one of the fifteenth to twenty-first aspects, including:
forming the Ag layer 1 by electroplating using an Ag plating solution 1 containing potassium silver cyanide, potassium cyanide, and potassium selenocyanate under conditions of a solution temperature of 10 to 35°C and a current density of 3 to 15 A/dm²,
wherein the Ag plating solution 1 is an aqueous solution containing: 80 to 130 g/L of silver,
   60 to 160 g/L of potassium cyanide, and
   50 to 80 mg/L of selenium.

According to a twenty-third aspect of the present invention, there is provided the method for producing an Ag-coated material according to the twenty-second aspect,
wherein 55 to 70 mg/L of the selenium is contained.

According to a twenty-fourth aspect of the present invention, there is provided the method for producing an Ag-coated material according to the twenty-second or twenty-third aspect,
wherein the electroplating is performed under a condition that a product of a concentration of potassium cyanide in the Ag plating solution 1 and a current density is 840 g·A/L·dm² or less.

According to a twenty-fifth aspect of the present invention, there is provided the method for producing an Ag-coated material according to any one of the fifteenth to twenty-fourth aspect, including:
forming the Ag layer 2 by electroplating using a silver plating solution 2 containing potassium silver cyanide, potassium cyanide, and potassium selenocyanate at a solution temperature of 10 to 40°C and a current density of 3 to 10 A/dm²,
wherein the silver plating solution 2 is an aqueous solution containing:
   80 to 110 g/L of silver,
   70 to 160 g/L of potassium cyanide, and
   1 to 15 mg/L of selenium.

According to a twenty-sixth aspect of the present invention, there is provided the method for producing an Ag-coated material according to any one of the thirteenth to twenty-fifth aspect, including:
forming an underlying layer comprising Ni on the base material; and
forming the Ag film on the underlying layer.

According to a twenty-seventh aspect of the present invention, there is provided the method for producing an Ag-coated material according to any one of the thirteenth to twenty-sixth aspect,
wherein the base material comprises Cu or Cu alloy.

According to a twenty-eighth aspect of the present invention, there is provided a terminal component, wherein the Ag-coated material according to any one of the first to twelfth aspects is used as a constituent material.

### Advantage of the Invention

The present invention can provide a silver-coated material excellent in heat-resistant adhesion and bending workability, and a method for producing the same.

### Brief description of the drawings

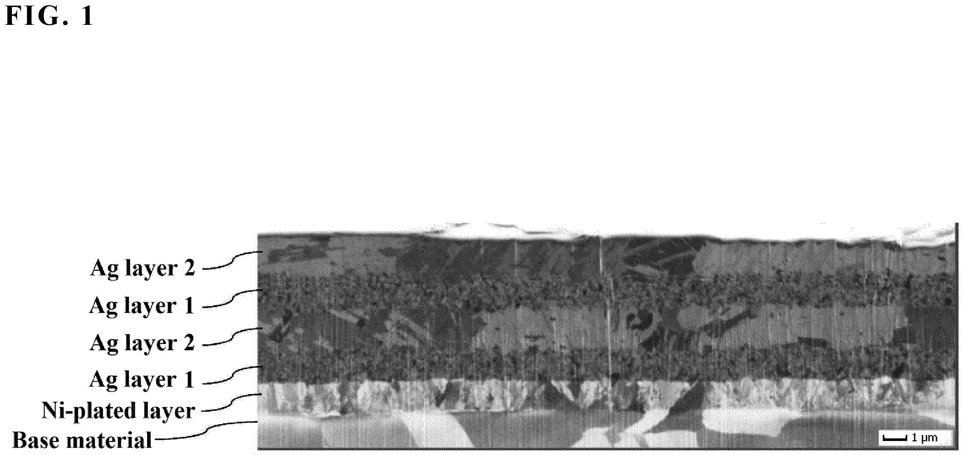

FIG. 1 is a photograph showing a SIM (scanning ion microscope) image of a cross section of an Ag-coated material of example 1.

### Detailed description of the Invention

Hereinafter, the present embodiment will be described. In this specification, "-" refers to a predetermined numerical value or more and a predetermined numerical value or less. Hereinafter, embodiments of the Ag-coated material of the present invention, a method for producing the same, and the like will be described.

### [Ag-coated material]

Each configuration of the embodiment of the Ag-coated material of the present invention will be described below.

### <Material>

According to an embodiment of the Ag-coated material of the present invention, it has a base material and an Ag film formed on the base material. A wide variety of materials conventionally used as base materials for contact points, terminal components, and the like can be used as the base material. A base material comprising Cu (copper), Cu alloy, or stainless steel is preferable from a viewpoint of corrosion resistance and mechanical properties, and in addition to the above points, a base material comprising Cu or Cu alloy is preferable from a viewpoint of conductivity. The Cu alloy preferably contains 90% by mass or more of Cu, and other metal elements constituting the Cu alloy include Ni, Sn, P, Si, Co, Fe, Mg, Zn, Ti, etc.

### <Ag film>

The Ag film formed on the base material includes Ag layers of alternately laminated at least three Ag layers with average crystal grain sizes different by three times or more. Further, it is preferable to have Ag layers of laminated four or more layers.

The above-described "average crystal grain sizes different by three times or more" means that in the adjacent Ag layers with different average crystal grain sizes, when the average crystal grain size of the Ag layer with a large average crystal grain size (referred to as D2) is divided by the average crystal grain size of the Ag layer with a smaller average crystal grain size (referred to as D1), the result is 3 or more, that is, D2/D1≥3. The Ag layers of alternately laminated three Ag layers with average crystal grain sizes different from each other by three times or more means that an Ag layer with a small average crystal grain size (average grain size = D1a), an Ag layer with a large average crystal grain size (average grain size = D2), and an Ag layer with a small average crystal grain size (average grain size = D1b) are laminated in this order, and both D2/D1a and D2/D1b are 3 or more. An order of lamination may be the Ag layer with a large average crystal grain size, the Ag layer with a small average crystal grain size, and the Ag layer with a large average crystal grain size.

Further, preferably, the Ag film includes Ag layers of alternately laminated Ag layer 1 comprising Ag with a small average crystal grain size and Ag layer 2 comprising Ag with an average crystal grain size larger than that of the Ag layer 1 (three times or more), from a side closer to the base material.

The Ag film formed on the base material (or underlying layer to be described later) is preferably a laminate having a four-layer structure in which two Ag layers 1 and 2 are alternately laminated, which are layers comprising Ag (silver) having a predetermined preferential orientation plane. Ag layers that are difficult to distinguish as a plurality of Ag layers (for example, the film thickness is very small like an Ag strike plating layer described later. For example, Ag layers with a very small film thickness of 0.1 µm or less), are not counted as a plurality of layers.

### (Ag layer 1)

The Ag layer 1 is a layer comprising Ag with an average crystal grain size smaller than that of the Ag layer 2 described later. The average crystal grain size (area average grain size) of the Ag layer 1 is preferably 0.005 µm or more, and preferably 0.2 µm or less. Further, it is preferably 0.15 µm or less.

Further, the Ag layer 1 preferably comprises Ag having {111} plane as a preferential orientation plane. The preferential orientation plane is the crystal plane corresponding to a highest intensity diffraction peak of each X-ray diffraction peak of 111 diffraction peak, 200 diffraction peak, 110 diffraction peak and 311 diffraction peak when the surface of the Ag layer 1 is subjected to X-ray diffraction analysis. Details of how to obtain the preferential orientation plane will be described later in examples.

The Ag layer 1 is considered to have high hardness and contributes to an excellent wear resistance of the Ag-coated material of the present invention.

Although the thickness of the Ag layer 1 is not particularly limited, it is preferably 0.5 to 5 µm, more preferably 0.7 to 3 µm, from a viewpoint of its function, cost and bending workability.

The Ag layer 1 may contain, for example, 1.0% by mass or less, or 0.5% by mass or less of elements such as Se and Sb, and unavoidable impurities. From a viewpoint of electrical conductivity, the Ag layer 1 preferably contains 99.9% by mass or more of Ag.

### (Ag layer 2)

The Ag layer 2 is a layer comprising Ag with an average crystal grain size three times or more (preferably four times or more, more preferably five times or more) larger than that of the Ag layer 1. The average crystal grain size (area average grain size) of the Ag layer 2 is preferably 0.3 µm or more, more preferably 0.4 µm or more, and preferably 1.0 µm or less.

It is preferable that a difference between the average crystal grain size of the Ag layer 2 and the average crystal grain size of the Ag layer 1 is a predetermined value or more (or within a predetermined range). For example, the difference is preferably 0.2 µm or more, more preferably 0.3 µm or more, and preferably 2 µm or less, more preferably 1 µm or less.

Further, the surface of the Ag layer 2 constituting the Ag film preferably comprises Ag having {100} plane as a preferential orientation plane.

The Ag layer 2 is easily deformed when subjected to bending, and contributes to excellent bending workability of the Ag-coated material of the present invention.

Although the thickness of the Ag layer 2 is not particularly limited, it is preferably 0.5 to 5 µm, more preferably 0.7 to 3 µm, from a viewpoint of its function, cost and bending workability.

The Ag layer 2 may contain, for example, 1.0% by mass or less, or 0.5% by mass or less of elements such as Se and Sb, and unavoidable impurities. The Ag layer 1 preferably contains 99.9% by mass or more of Ag from a viewpoint of electrical conductivity.

### (Lamination of Ag layer 1 and Ag layer 2)

The Ag film is a laminate formed by alternately laminating the Ag layer 1 and Ag layer 2 described above. With such a laminate structure, the Ag film has excellent heat-resistant adhesion with the base material (or the underlying layer described later) compared to a case of a plated layer of one of the Ag layer 1 or the Ag layer 2, and also with such a laminate structure, it is considered that separation between layers is less likely to occur.

Regarding bending workability, it is considered that cracks occur when a starting point of a crack is generated at one of the layers in the Ag film during bending, and this extends vertically (crack propagation) and penetrates vertically. Then, when the Ag-coated material is folded, it is considered that the farther the layer from the base material (closer to the surface) among the constituent layers of the Ag film is, the greater the tensile stress generated, and the more likely the starting point of cracks is to occur. In the present invention, since the Ag film is a laminate of the Ag layers of three or more layers, preferably four or more layers, propagation of cracks is stopped at an interface of each layer, which is considered to contribute to the excellent bending workability of the Ag-coated material of the present invention.

The excellent heat-resistant adhesion and bending workability described above cannot be exhibited if the laminate includes a total of two layers, one Ag layer 1 and one Ag layer 2, and in order to exhibit the effect, it is necessary to form a laminate of three or more layers, preferably four or more layers.

A specific example of the laminate structure including a positional relationship between the Ag layers 1 and 2 in the Ag film described above and the base material (underlying layer) is as follows.
Base material (underlying layer)-Ag layer 1-Ag layer 2-Ag layer 1-Ag layer 2
Base material (underlying layer)-Ag layer 2-Ag layer 1-Ag layer 2-Ag layer 1

It is preferable that the Ag layer 2 is an outermost layer of the Ag-coated material.

A thickness ratio of the Ag layer 1 and the Ag layer 2 is not limited, but it is preferably 0.5 ≤ (thickness of Ag layer 1/thickness of Ag layer 2) ≤ 5.0.

### <Other layers>

According to an embodiment of the Ag-coated material of the present invention, it has the base material and Ag film described above, and may further have other layers depending on the purpose.

For example, especially when the base material comprises Cu or Cu alloy, in order to prevent Cu and alloy components in the base material from diffusing into the Ag film and degrading the heat resistance, it is desirable that an underlying layer comprising Ni (nickel) is formed between the base material and the Ag film. Although the thickness of the underlying layer is not particularly limited, it is preferably 0.3 to 2 µm, more preferably 0.5 to 1.5 µm, from a viewpoint of its function and cost.

For example, when producing an Ag-coated material by a method for producing an Ag-coated material described later, a very thin intermediate layer of Ag may be formed between the base material or substrate and the Ag coated material.

### <Vickers hardness of the Ag-coated material>

A Vickers hardness of the Ag-coated material of the present invention is preferably 98 or higher, more preferably 100 or higher (unit: kgf/mm²). The Vickers hardness of 135 or less is preferable because excessively high hardness may adversely affect bending workability.

The Vickers hardness of the Ag-coated material is the Vickers hardness obtained for the surface of the Ag-coated material, and the surface is the surface of the Ag-coated material where the Ag film is formed. Details of the Vickers hardness measurement method will be described later in examples.

### <Method for confirming Ag layers 1 and 2 in the Ag film>

In the Ag-coated material of the present invention, whether the Ag-coated film has the above-described configuration (crystal grain size, preferential orientation plane, etc.) can be confirmed, for example, by the following method.

First, it can be confirmed that the Ag film has a structure of three or more layers, by creating a cross-sectional sample perpendicular to the surface of the Ag-coated material and observing this sample with a scanning microscope or scanning ion microscope. Since the Ag layer 1 has a smaller crystal grain size than the Ag layer 2, it can be distinguished by large/small of the crystal grain size.

Further, the surface of the Ag coated material can be analyzed by X-ray diffraction (XRD) or EBSD (Electron Backscatter Diffraction Pattern) analysis to determine the preferential orientation plane of the outermost layer of the Ag film. Next, the outermost layer is removed by a known method (for example, polishing, milling, sputtering, etching, etc.), and the preferential orientation plane is determined similarly for the second layer from the top. By repeating this, it can be confirmed that the Ag film has a structure of three or more layers of Ag layers 1 and 2 defined in the present invention.

### [Method for producing an Ag-coated material]

Next, an embodiment of the method for producing an Ag-coated material according to the present invention will be described.

This production method is characterized by forming an Ag film by alternately laminating at least three Ag layers on the base material, with average crystal grain sizes different by 3 times or more. It is preferable to form the Ag film by laminating four or more Ag layers.

Further, it is preferable to employ a production method in which the Ag layer 1 comprising Ag with a small average crystal grain size and the Ag layer 2 comprising Ag with an average crystal grain size three times or more larger than that of the Ag layer 1, are alternately formed on the base material, to form an Ag film including three or more Ag layers. Further, it is preferable to form an Ag-coated material in which the preferential orientation plane of the Ag layer 1 is {111} plane and the preferential orientation plane of the Ag layer 2 is {100} plane. The base material is the same as described above in the embodiment of the Ag-coated material of the present invention.

### <Ag film>

As described above, the Ag film includes three or more Ag layers of alternately laminated Ag layers 1 and Ag layers 2. The Ag layers 1 and 2 are the same as those described above in the embodiment of the Ag-coated material of the present invention. A method for forming the Ag layers 1 and 2 will be described below. Prior to the formation of the Ag film, pretreatment (electrolytic degreasing, pickling, etc.) may be applied to the base material on which the underlying layer is formed as necessary.

### (Formation of the Ag layer 1)

The Ag layer 1 can be formed by a known method (for example, the method disclosed in Patent document 1). As a method for forming the Ag layer 1, plating is preferable from a viewpoint of the base material, the adhesion with the underlying layer or the Ag layer 2, and a production cost.

More specifically, it is preferable to form the Ag layer 1 by performing electroplating (to the base material, the underlying layer, or the Ag layer 2), under conditions of liquid temperature of 10 to 35°C and current density of 3 to 15 A/dm², using Ag plating solution 1 containing potassium silver cyanide, potassium cyanide, and potassium selenocyanate. The Ag plating solution 1 is an aqueous solution containing 80 to 130 g/L (preferably 80 to 110 g/L) silver, 60 to 160 g/L (preferably 70 to 160 g/L) potassium cyanide, and 50 to 80 mg/L (preferably 55 to 70 mg/L) selenium. (When ionized, potassium silver cyanide and potassium selenocyanate produce cyan ions and potassium ions, but these are not included in the concentration of the above potassium cyanide.) When electroplating is performed using such an Ag plating solution with a high selenium concentration, a silver layer having {111} plane as a preferential orientation plane can be preferably formed. Further, from a viewpoint of suitably forming a silver layer with a preferential orientation plane of {111} plane, this electroplating is preferably performed under a condition that the product of the concentration of potassium cyanide in the Ag plating solution 1 and a current density is 840 g·A/L·dm² or less, and from the same point of view, it is preferable to perform under a condition that the product is 250 g·A/L·dm² or more.

Further, the Ag plating solution 1 may be an aqueous solution containing 74 to 203 g/L of potassium silver cyanide, 70 to 160 g/L of potassium cyanide, and 73 to 128 mg/L of potassium selenocyanate.

### (Formation of the Ag layer 2)

The Ag layer 2 can be formed by a known method (for example, a method disclosed in Patent document 2). As a method for forming the Ag layer 2, plating is preferable from a viewpoint of a base material, adhesion with an underlying layer or the Ag layer 1, and a production cost.

More specifically, it is preferable to form the Ag layer 2 by performing electroplating (to the base material, the underlying layer or the Ag layer 1) under conditions of a liquid temperature of 10 to 40°C and a current density of 3 to 10 A/dm², using a silver plating solution 2 containing potassium silver cyanide, potassium cyanide, and potassium selenocyanate. The silver plating solution 2 is an aqueous solution containing 80 to 110 g/L of silver, 70 to 160 g/L of potassium cyanide, and 1 to 15 mg/L of selenium. (When ionized, potassium silver cyanide and potassium selenocyanate produce cyanide and potassium ions, but these are not included in the concentration of the above potassium cyanide.) When electroplating is performed using the Ag plating solution containing a small amount of selenium in this manner, a silver layer having {100} plane as a preferential orientation plane can be preferably formed.

Further, the Ag plating solution 1 may be an aqueous solution containing 74 to 203 g/L of potassium silver cyanide, 70 to 160 g/L of potassium cyanide, and 3 to 30 mg/L of potassium selenocyanate.

### (Average crystal grain size)

By the specific method for producing the Ag layer 1 and Ag layer 2 as described above, there is provided a method for producing an Ag film including three or more Ag layers, by alternately forming Ag layer 1 comprising Ag with a small average crystal grain size and the Ag layer 2 comprising Ag with a larger average crystal grain size than the Ag layer 1, on the base material. At this time, when the average crystal grain size of the Ag layer 1 is D1 and the average crystal grain size of the Ag layer 2 is D2, D2/D1≥3 is satisfied.

Further, there is provided a method for producing an Ag-coated material in which the Ag layer 1 has an average crystal grain size (area average grain size) of 0.2 µm or less and the Ag layer 2 has an average crystal grain size (area average grain size) of 0.3 µm or more.

Further, the Ag layer 1 preferably has a thickness of 0.5 to 5 µm, and the Ag layer 2 preferably has a thickness of 0.5 to 5 µm.

### (Ag strike plating)

Before forming the Ag film on the base material or underlying layer, it is preferable to form a very thin intermediate layer by Ag strike plating to improve adhesion between the base material or the underlying layer and the Ag film.

### <Other layers>

As described above in the description of the embodiment of the Ag-coated material, according to the present invention, other layers (underlying layer comprising nickel, etc.) may be formed in addition to the base material and the Ag film.

When forming the underlying layer comprising nickel on the base material, a known method can be employed without particular limitation as a method for forming this underlying layer, and electroplating is preferable from a viewpoint of adhesion with the base material and a production cost.

Further, when the wear resistance is emphasized in the produced Ag-coated material, it is preferable to form the Ag layer 1 as the outermost layer (formation method is the same as above), and when the bending workability is emphasized, it is preferable to form the Ag layer 2 as the outermost layer (formation method is the same as above).

### [Terminal component]

The Ag-coated material produced by the embodiment of the Ag-coated material and the method for producing the Ag-coated material of the present invention described above, is excellent in heat-resistant adhesion, bending workability, and wear resistance, and is therefore suitable as a material for forming contacts and terminal components.

The technical scope of the present invention is not limited to the above-described embodiments, and includes various modifications and improvements within a range where specific effects obtained by the constituent elements of the invention and their combinations can be derived.

For example, the present embodiment shows that the Ag film includes Ag layers of alternately laminated two Ag layers 1 and 2 from the side closer to the base material. On the other hand, when the Ag layers with different average crystal grain sizes are alternately laminated, at least three layers may be laminated. For example, Ag layer 1, Ag layer 2, and Ag layer 1 may be laminated, or Ag layer 2, Ag layer 1, and Ag layer 2 may be laminated, from the side closer to the base material. Also, the Ag film may include four or more Ag layers. For example, Ag layer 1, Ag layer 2, Ag layer 1, Ag layer 2, Ag layer 1, Ag layer 2 may be laminated, or Ag layer 2, Ag layer 1, Ag layer 2, Ag layer 1, Ag layer 2, Ag layer 1 may be laminated, from the side closer to the base material.

### Example

Next, the present invention will be specifically described by showing examples. The invention is not limited to the following examples. Contents not described below are the same as those described in the present embodiment.

Examples of a silver-plated material and a method for producing the same according to the present invention will be described below in detail.

### [Example 1]

### (Pretreatment: electrolytic degreasing and pickling)

First, a rolled plate comprising pure copper (C1020) of 67 mm × 50 mm × 0.3 mm was prepared as a base material (material to be plated), and the material to be plated and a SUS plate were immersed in an alkaline degreasing solution, electrolytically degreased at a voltage of 5 V for 30 seconds, with the material to be plated as a cathode and the SUS plate as an anode, and washing with water was performed for 15 seconds, and pickling in an aqueous 3% sulfuric acid solution was performed for 15 seconds, and washing with water was performed for 15 seconds.

### (Ni plating)

Next, in a nickel plating solution which was an aqueous solution containing 25 g/L nickel chloride, 35 g/L boric acid, and 540 g/L nickel sulfamate tetrahydrate, electroplating (nickel plating) was performed, with a pretreated material to be plated as a cathode, and a SK nickel electrode plate as an anode, until a thickness reached 1 µm, while stirring at 500 rpm with a magnetic stirrer, under conditions of a liquid temperature of 55°C and a current density of 7 A/dm, to thereby form an underlying layer comprising nickel, and then washing with water was performed for 15 seconds.

### (Ag strike plating)

Next, in an Ag strike plating solution which was an aqueous solution containing 3 g/L potassium silver cyanide and 90 g/L potassium cyanide, electroplating (silver strike plating) was performed, with a material to be plated having an underlying layer thereon as a cathode, and a titanium electrode plate coated with platinum as an anode, for 10 seconds while stirring at 500 rpm with a stirrer, under conditions of a liquid temperature of 18°C and a current density of 2 A/dm², and washing with water was performed for 15 seconds.

### (Ag plating step A)

Next, in the Ag plating solution which was an aqueous solution containing 175 g/L potassium silver cyanide (KAg(CN)₂) (silver concentration is 95 g/L), 95 g/L potassium cyanide (KCN), and 55 mg/L Se (selenium), electroplating (Ag plating) was performed until a thickness of the Ag-plated film reached 1.25 µm, with an Ag strike-plated material to be plated as a cathode, and an Ag electrode plate comprising Ag with a purity of 99.99% by mass or more as an anode, while stirring at 500 rpm with a stirrer, under conditions of a liquid temperature of 18°C and a current density of 5 A/dm², and washing with water was performed for 15 seconds, and drying was performed with air pressure from an air gun, to thereby obtain a material to be plated having a first Ag-plated film (layer) thereon. This Ag plating step is called "Ag plating step A" in this specification. Se in the Ag plating solution was supplied by adding potassium selenocyanate.

### (Evaluation of crystal orientation)

The surface of the first Ag-plated film thus obtained was evaluated by a Cu tube and Kβ filter method, using an X-ray diffraction analysis device (Fully automatic multi-purpose horizontal X-ray diffraction device Smart Lab manufactured by Rigaku Denki Co., Ltd.). From an X-ray diffraction pattern obtained by scanning at a scanning range 2θ of 5 to 120 deg and a scanning speed of 50 deg / min, a corrected intensity was obtained, which was an intensity obtained by dividing X-ray diffraction peak intensity (intensity of X-ray diffraction peak) of each of 111 diffraction peak, 200 diffraction peak, 220 diffraction peak and 311 diffraction peak of the Ag-plated film, by each relative intensity ratio (111:200:220:311=100:40:25:26) described in JCPDS card No.40783. The crystal plane corresponding to the X-ray diffraction peak with a highest corrected intensity was taken as a preferential orientation plane of the first Ag-plated film. The result reveals that the preferential orientation plane was {111} plane.

### (Ag plating step B)

Next, in a silver plating solution which is an aqueous solution containing 175 g/L potassium silver cyanide (KAg(CN)₂) (silver concentration is 95 g/L), 95 g/L potassium cyanide (KCN) and 6 mg/L Se (selenium), electroplating (Ag plating) was performed until the thickness of the Ag-plated film reached 1.25 µm, with a material to be plated having the first layer of the Ag-plated film thereon as a cathode, and an Ag electrode plate comprising Ag with a purity of 99.99% by mass or more as an anode, while stirring at 500 rpm with a stirrer, under conditions of a liquid temperature of 18°C and a current density of 5 A/dm², and then washing with water was performed for 15 seconds and drying with air pressure from an air gun was performed, to thereby obtain a material to be plated having a second Ag-plated film (layer) thereon.

This Ag plating step is called "Ag plating step B" in this specification. Se in the Ag plating solution was supplied by adding potassium selenocyanate.

Further, a result of evaluation by X-ray diffraction of the Ag-plated film produced under the same condition in comparative example 2 described later, reveals that the preferential orientation plane of the second Ag-plated film in this step is {100} plane.

### (Ag plating step A (second time))

Next, a sample having the second Ag-plated film thereon was used as a material to be plated, and electroplating (Ag plating) was performed in the same manner as in the "Ag plating step A", and then washing with water was performed for 15 seconds, to thereby obtain a material to be plated having a third Ag-plated film thereon.

### (Ag plating step B (second time))

Next, electroplating (Ag plating) was performed in the same manner as in the "Ag plating step B", using a sample having a third Ag-plated film thereon as a material to be plated, and then washing with water was performed for 15 seconds and drying with air pressure from an air gun was performed, to thereby obtain a material to be plated (that is, an Ag-coated material) having a fourth Ag-plated film thereon.

As described above, an Ag-coated material formed with the Ag film including four layers each having a thickness of 1.25 µm and a total thickness of 5 µm was obtained. Further, Ag purities (concentrations) of these Ag-plated layers were all 99.9% by mass or more.

For this Ag-coated material, the cross-sectional crystal grain size, bending workability, heat-resistant adhesion, Vickers hardness, contact resistance, and wear resistance of each Ag layer were evaluated.

FIG. 1 is a photograph showing a SIM (scanning ion microscope) image of the cross section of the Ag-coated material of example 1.

As shown in FIG. 1, a base material, Ni-plated layer, Ag-plated film as a first layer by Ag plating step A, Ag-plated film as a second layer by Ag plating step B, Ag-plated film as a third layer by Ag plating step A, Ag-plated film as a fourth layer by Ag plating step B, are confirmed from the bottom. Since the Ag strike plated layer is thin, it is difficult to see in FIG. 1.

### (Crystal grain size)

The Ag-coated material was cut and an average crystal grain size (area average grain size) of the cross section was measured by the Area Fraction method in EBSD analysis.

Details are as follows. A section obtained by cutting the Ag-coated material was milled using a cross-section polisher (IB-09010CP manufactured by JEOL Ltd.) to make a mirror surface. For this section, EBSD measurement was performed with an acceleration voltage of 15 kV, a magnification of 20000 times, a measurement field of view of 5.0 µm × 10.0 µm, and a step size of 20 nm, using a field emission Auger microprobe (JAMP-9500F manufactured by JEOL Ltd.) equipped with an electron beam backscatter diffraction (Electron BackScatter Diffraction (EBSD) analyzer (OIM Analysis manufactured by TSL Solutions Co., Ltd.).

Based on this measurement result, an Inverse Pole Figure (IPF) map was created, using data collection software (OIM-DC manufactured by TSL Solutions Co., Ltd.) and data analysis software (OIM manufactured by TSL Solutions Co., Ltd.).

Based on this IPF map, an average crystal grain size (area average grain size) was calculated based on an Area Fraction method using the data analysis software described above, with a boundary where a crystal orientation difference between adjacent pixels is 5° or more regarded as a grain boundary, except for measurement points where a reliability index (confidence Index (CI) value) analyzed by the above data analysis software is 0.1 or less.

The result reveals that the average crystal grain size (area average grain size) was 0.080 µm for the first layer, 0.420 µm for the second layer, 0.080 µm for the third layer, and 0.563 µm for the fourth layer, from the side closer to the substrate.

### (Bending workability)

Bending workability of the Ag-coated material was evaluated as follows, according to a V block method of JIS Z2248:
After bending the Ag-coated material perpendicularly to a rolling direction of a base material at 90 degrees at two levels of bending radius R = 1.0 mm and R = 0.5 mm, the bent portion was magnified 500 times with a microscope (Keyence digital microscope VHX-1000), and the bending workability was observed and evaluated by the presence or absence of exposure of the base material (Ni plating or Cu material) of the bent portion (Mountain folding part). The bending radius R is the radius of a curved portion of a pusher that is pressed against the Ag-coated material and bent, and a value R/t obtained by dividing the bending radius R by a plate thickness t is 3.3 (when R=1.0) and 1.67 (when R=0.5) respectively.

The result reveals that no exposure of the base material was observed when the material was bent with any bending radius, and the bending workability was good.

### (Heat resistant adhesion)

Two test pieces (50 mm × 10 mm) were cut out from this Ag-coated material, with one test piece as a flat test piece, and the other test piece subjected to embossing (hemispherical stamping with inner R = 1.5 mm) to make an embossed test piece (indenter), and a convex part of the embossed test piece was brought into contact with the flat test piece, then, both were sandwiched and fixed with a gem clip (TANOSE gem clip: large size 28mm, type TG-2G), and put in a 200°C constant temperature bath (AS ONE Co., Ltd. constant temperature bath OF-450) and held for 120 hours, then taken out. Then, the gem clip was removed to separate the two test pieces. Three sets of such test pieces were prepared and evaluated.

This separated flat test piece and the portion where the embossed test piece was brought into contact with this flat test piece were observed with an objective lens of x50 using a microscope (Keyence Corporation shape analysis laser microscope VK-X150), and a case in which exposure of the Ni-plated layer, which is the underlying layer, was observed in any one of the three sets of test pieces (That is, when peeling of Ag plating is observed) was judged to be NG, and a case in which no underlying layer was observed in all three sets was judged to be Good. When it is difficult to determine whether the Ni-plated layer is exposed or not, it can be confirmed with an EPMA (electron probe microanalyzer).

As a result of the above evaluation, all three sets of test pieces were Good, indicating excellent heat-resistant adhesion.

Only in example 1, the heat-resistant adhesion was evaluated even under a condition of holding at 200°C for 1000 hours. The result reveals that all three sets of test pieces were Good, indicating excellent heat-resistant adhesion.

### (Vickers hardness)

The Vickers hardness HV of the surface of the Ag-coated material was measured according to JIS Z2244, by forming an indentation with a measuring load of 10 gf with a falling time of 3 seconds, a holding time of 10 seconds, and a rising time of 3 seconds, using a microhardness tester (HM-221 manufactured by Mitutoyo Co., Ltd.). The result reveals that the Vickers hardness HV was 110. When the Vickers hardness HV is 98 or more, good wear resistance is expected.

### (Contact resistance)

A contact resistance value was measured, by cutting out two test pieces from the Ag-coated material, with one of the test pieces used as a flat test piece, the other test piece used as an embossed test piece (by hemispherical punching process with inside R = 1.5 mm) to make an embossed test piece (indenter), and making a convex portion of the embossed test piece brought into contact with the flat test piece with a load of 5 N, at a measurement current of 10 mA, using a precision sliding tester CRS-G2050-DWA manufactured by Yamazaki Seiki Laboratory Co., Ltd. The result reveals that the contact resistance was 0.4 mQ.

### (Wear resistance)

The number of times until the copper material was exposed was measured, by cutting out two test pieces from the Ag-coated material, with one of the test pieces used as a flat test piece, the other test piece used as an embossed test piece (by hemispherical punching process with inside R = 1.5 mm) to make an embossed test piece (indenter), and making a convex portion of the embossed test piece brought into contact with the flat test piece with a load of 5 N, and by reciprocating sliding at a sliding speed of 1.67 mm/s and a sliding distance of 5 mm using a precision sliding tester CRS-G2050-DWA manufactured by Yamazaki Seiki Laboratory Co., Ltd. The result reveals that the copper material was not exposed until after 80 times of reciprocating sliding motion, indicating excellent wear resistance.

### [Example 2]

An Ag-coated material including four layers of Ag plating was produced by the same production method as in example 1, except that an Ag-plated layer with a thickness of 2.5 µm was formed in the Ag plating step A, and an Ag-plated layer with a thickness of 2.5 µm was formed in the Ag plating step B, to form an Ag-plated film with a total thickness of 10 µm. Further, Ag purities (concentrations) of these Ag-plated layers were all 99.9% by mass or more. Further, as in example 1, the ratio of the average crystal grain sizes of adjacent Ag-plated layers was 3 or more.

The bending workability of this Ag-plated material was evaluated in the same manner as in example 1. As a result, when bending radius R was 1.0 mm, no exposure of the base material was observed and the bending workability was good. Further, exposure of the base material was confirmed under a condition that the bending radius was 0.5 mm.

Further, when heat-resistant adhesion was evaluated in the same manner as in example 1, all three sets of test pieces were good, indicating excellent heat-resistant adhesion.

### [Example 3]

An Ag-coated material including four layers of Ag plating was produced by the same production method as in example 1, except that an Ag-plated layer with a thickness of 1 µm was formed in the Ag plating step A as a first layer, an Ag-plated layer with a thickness of 1 µm was formed in the Ag plating step B as a second layer, an Ag-plated layer with a thickness of 1 µm was formed in the step A as a third layer, and an Ag-plated layer with a thickness of 2 µm was formed in the Ag plating step B as a fourth layer from the base material side, to form an Ag-plated film with a total thickness of 5 µm. Further, Ag purities (concentrations) of these Ag-plated layers were all 99.9% by mass or more. Further, as in example 1, the ratio of the average crystal grain sizes of the adjacent Ag-plated layers was 3 or more.

The bending workability of this Ag-plated material was evaluated in the same manner as in example 1. The result reveals that when the bending radius R was 1.0 mm, no exposure of the base material was observed and the bending workability was good. Further, exposure of the base material was confirmed under a condition that the bending radius was 0.5 mm.

Further, when heat-resistant adhesion was evaluated in the same manner as in example 1, all three sets of test pieces were good, indicating excellent heat-resistant adhesion.

### [Comparative example 1]

An Ag-coated material was produced in the same manner as in example 1, except that the first Ag-plated layer was formed until the thickness reached 5 µm (in the "Ag plating step A"), and the second, third, and fourth Ag-plated layers were not formed. In other words, the Ag film is a single layer of only the first layer.

When the surface of this Ag-coated material was evaluated in the same manner as the evaluation of crystal orientation in example 1, the preferential orientation plane was {111} plane.

As in example 1, for this Ag-plated material, bending workability, heat-resistant adhesion, Vickers hardness, contact resistance, and wear resistance were evaluated. The result reveals that for the bending workability, exposure of the base material was confirmed in both bending radii R of 1.0 mm and 0.5 mm, indicating poor bending workability, and the heat-resistant adhesion was NG. Further, the Vickers hardness HV was 140, the contact resistance was 0.6 mQ, and the wear resistance shows that the copper material was not exposed even after 80 times of reciprocating sliding motion, indicating excellent wear resistance.

### [Comparative example 2]

An Ag-plated material was produced in the same manner as in example 1, except that the first Ag-plated layer was formed until the thickness reached 5 µm in the "Ag plating step B", and the second, third, and fourth Ag-plated layers were not formed. In other words, the Ag film is a single layer of only the first layer.

When the surface of this Ag-coated material was evaluated in the same manner as the evaluation of crystal orientation in example 1, the preferential orientation plane was {100} plane.

For this Ag-coated material, heat-resistant adhesion, Vickers hardness, contact resistance, and wear resistance were evaluated in the same manner as in example 1. The result reveals that exposure of the base material was not confirmed under the condition that the bending radius R was 1.0 mm, indicating excellent bending workability. Exposure of the base material was confirmed under the condition of 0.5 mm. The heat-resistant adhesion was NG. Further, the Vickers hardness HV was 90, the contact resistance was 0.2 mQ, and the copper material was exposed after 50 reciprocating sliding motion, indicating poor wear resistance.

### [Comparative example 3]

After Ag strike plating, an Ag-coated material was produced in the same manner as in example 1, except that in an Ag plating solution that is an aqueous solution containing 115 g/L of potassium silver cyanide (KAg(CN)₂), 60 g/L of potassium cyanide (KCN), and 32 mg/L of Se (selenium), electroplating (Ag plating) was performed until the thickness of the Ag-plated film reaches 5 µm, with an Ag strike-plated material to be plated as a cathode, and an Ag electrode plate comprising Ag with a purity of 99.99% by mass or more as an anode, while stirring at 500 rpm with a stirrer, at a liquid temperature of 30°C and a current density of 2 A/dm², then, washing with water was performed for 15 seconds and drying with air pressure from an air gun was performed, to obtain the first Ag-plated layer, and the second, third and fourth Ag-plated layers were not formed. In other words, the Ag film is a single layer of only the first layer.

In the specification of the present application, the step of forming the first Ag-plated layer is referred to as "Ag plating step C".

When the surface of this Ag-coated material was evaluated in the same manner as the evaluation of the crystal orientation in example 1, the preferential orientation plane was {110} plane.

For this Ag-coated material, bending workability, heat-resistant adhesion, and Vickers hardness were evaluated in the same manner as in example 1. The result reveals that exposure of the base material was confirmed in both bending radii R of 1.0 mm and 0.5 mm, indicating poor bending workability, and the heat-resistant adhesion was NG. The Vickers hardness HV was 110.

### [Comparative example 4]

An Ag-coated material was produced in the same manner as in example 1, except that the first Ag-plated layer was formed until the thickness reached 2.5 µm in the "Ag plating step B", and the second Ag-plated layer was formed until the thickness reached 2.5 µm in the "Ag plating step A", and the third and fourth Ag-plated layers were not formed. In other words, the Ag-coated film includes two Ag-plated layers.

For this Ag-coated material, bending workability and heat-resistant adhesion were evaluated in the same manner as in example 1. The result reveals that exposure of the base material was not confirmed under the condition that the bending radius R was 1.0 mm, indicating excellent bending workability. Exposure of the base material was confirmed under a condition that the bending radius R was 0.5 mm. Further, the heat-resistant adhesion was NG.

### [Comparative example 5]

An Ag-coated material was produced in the same manner as in example 1, except that the first Ag-plated layer was formed until the thickness reached 2.5 µm in the "Ag plating step A", the second Ag-plated layer was formed until the thickness reached 2.5 µm in the "Ag plating step B", and the third and fourth Ag-plated layers were not formed. In other words, the Ag-coated film includes two Ag-plated layers.

For this Ag-coated material, bending workability and heat-resistant adhesion were evaluated in the same manner as in example 1. The result reals that under the condition that the bending radius R was 1.0 mm, no exposure of the base material was confirmed, indicating excellent bending workability. Exposure of the base material was confirmed under the condition that the bending radius R was 0.5 mm. Further, the heat-resistant adhesion was NG.

### [Comparative example 6]

An Ag-coated material was produced in the same manner as in example 1, except that the first Ag-plated layer was formed until the thickness reached 2.5 µm in the "Ag plating step C", the second Ag-plated layer was formed until the thickness reached 2.5 µm in the "Ag plating step B", and the third and fourth Ag-plated film were not formed. In other words, the Ag film includes two Ag-plated layers.

For this Ag-coated material, bending workability and heat-resistant adhesion were evaluated in the same manner as in example 1. The result reveals that the material was not exposed under the condition that the bending radius R was 1.0 mm, indicating excellent bending workability. Under the condition that the bending radius R was 0.5 mm, exposure of the substrate was confirmed. Further, the heat-resistant adhesion was NG.

### [Comparative example 7]

An Ag-coated material was produced in the same manner as in example 1, except that the first Ag-plated layer was formed until the thickness reached 2.5 µm in the "Ag plating step B", the second Ag-plated layer was formed until the thickness reached 2.5 µm in the "Ag plating step C", and the third and fourth layers were not formed. In other words, the Ag film includes two Ag-plated layers.

For this Ag-coated material, bending workability and heat-resistant adhesion were evaluated in the same manner as in example 1. The result reveals that the material was not exposed under the condition that the bending radius R was 1.0 mm, indicating excellent bending workability. The exposure of the base material was confirmed under the condition that the bending radius R was 0.5 mm. Further, the heat-resistant adhesion was NG.

### [Comparative example 8]

An Ag-coated material was produced in the same manner as in example 1, except that the first Ag-plated layer was formed until the thickness reached 2.5 µm in the "Ag plating step C", the second Ag-plated layer was formed until the thickness reached 2.5 µm in "Ag plating step A", and the third and fourth layers were not formed. In other words, the Ag film includes two Ag-plated layers.

For this Ag-coated material, bending workability and heat-resistant adhesion were evaluated in the same manner as in example 1. The result reveals that for the bending workability, exposure of the base material was confirmed in both bending radii R of 1.0 mm and 0.5 mm, indicating poor bending workability, and the heat-resistant adhesion was NG.

### [Comparative example 9]

An Ag-coated material was produced in the same manner as in example 1, except that the first Ag-plated layer was formed until the thickness reached 2.5 µm in the "Ag plating step A", the second Ag-plated layer was formed until the thickness reached 2.5 µm in the "Ag plating step C", and the third and fourth layers were not formed. In other words, the Ag film includes two Ag-plated layers.

For this Ag-coated material, bending workability and heat-resistant adhesion were evaluated in the same manner as in example 1. The result reveals that the exposure of the base material was confirmed in both bending radii R of 1.0 mm and 0.5 mm, indicating poor bending workability, and the heat-resistant adhesion was NG.

### [Comparative example 10]

An Ag-coated material was produced in the same manner as in example 1, except that the first Ag-plated layer was formed in the "Ag plating step C", the second Ag-plated layer was formed in the "Ag plating step B", the third Ag-plated layer was formed in the "Ag plating step C", and the fourth Ag-plated layer was formed in the "Ag plating step B". In other words, the Ag film includes four Ag-plated layers, the thickness of each Ag-plated layer was 1.25 µm, and a total thickness of an entire Ag-plated film was 5 µm.

As a result of measurement of an average crystal grain size (average particle size) of the Ag-coated material in the same manner as in example 1, the first layer was 0.213 µm, the second layer was 0.265 µm, the third layer was 0.119 µm, and the fourth layer was 0.251 µm, from the side closer to the substrate. In other words, the ratio of the average crystal grain size of each adjacent layer was less than 3.

For this Ag-coated material, bending workability and heat-resistant adhesion were evaluated in the same manner as in example 1. The result reveals that for the bending workability, exposure of the base material was confirmed in both bending radii R of 1.0 mm and 0.5 mm, indicating poor bending workability, and the heat-resistant adhesion was NG.

Further, the Ag purities (concentrations) of the Ag-plated layers of comparative examples 1 to 10 were all 99.9% by mass or more.

Table 1 shows production conditions and properties of the Ag-coated materials of these examples and comparative examples.

**[Table 1]**

| | Composition of Ag-plated film | | | | Evaluation | | |
|---|---|---|---|---|---|---|---|
| | First layer (base material side) | Second layer | Third layer | Fourth layer | Bending workability | Wear resistance | Heat resistant adhesion |
| | Thickness Preferential orientation plane | Thickness Preferential orientation plane | Thickness Preferential orientation plane | Thickness Preferential orientation plane | R=1.0 | Times | 200°C× 120h |
| Example 1 | 1.25µm {111} | 1.25µm {100} | 1.25µm {111} | 1.25µm {100} | Good | 80 | Good |
| Example 2 | 2.5µm {111} | 2.5µm {100} | 2.5µm {111} | 2.5µm {100} | Good | - | Good |
| Example 3 | 1µm {111} | 1µm {100} | 1µm {111} | 2µm {100} | Good | - | Good |
| Com.Ex. 1 | 5µm {111} | - | - | - | NG | 80 | NG |
| Com.Ex. 2 | 5µm {1 00} | - | - | - | Good | 50 | NG |
| Com.Ex. 3 | 5µm {110} | - | - | - | NG | - | NG |
| Com.Ex. 4 | 2.5µm {1 00} | 2.5µm {111} | - | - | Good | - | NG |
| Com.Ex. 5 | 2.5µm {111} | 2.5µm {100} | - | - | Good | - | NG |
| Cam.Ex. 6 | 2.5µm {110} | 2.5µm {100} | - | - | Good | - | NG |
| Com.Ex. 7 | 2.5µm {100} | 2.5µm {110} | - | - | Good | - | NG |
| Com.Ex. 8 | 2.5µm {110} | 2.5µm {111} | - | - | NG | - | NG |
| Cam_Ex_ 9 | 2.5µm {111} | 2.5µm {110} | - | - | NG | - | NG |
| Com.Ex. 10 | 1.25µm {110} | 1.25µm {100} | 1.25µm {110} | 1.25µm {100} | NG | - | NG |

| | | | | | | | |
|---|---|---|---|---|---|---|---|
| ∗ Com.Ex. = Comparative Example | | | | | | | |

As can be seen from Table 1, the Ag-coated material produced in example 1 has good bending workability, wear resistance, and heat-resistant adhesion.

## Claims

1. An Ag-coated material, including a base material and an Ag film on the base material, the Ag film including alternately laminated at least three Ag layers with average crystal grain sizes different by three times or more.

2. The Ag-coated material according to claim 1, wherein the Ag film includes Ag layers of four or more lamination.

3. The Ag-coated material according to claim 1 or 2, wherein the Ag film includes Ag layers of alternately laminated Ag layer 1 comprising Ag with a small average crystal grain size and Ag layer 2 comprising Ag with a larger average crystal grain size than the Ag layer 1, from a side closer to the base material.

4. The Ag-coated material according to claim 3, wherein an average crystal grain size (area average grain size) of the Ag layer 1 is 0.2 µm or less.

5. The Ag-coated material according to claim 3 or 4, wherein an average crystal grain size (area average grain size) of the Ag layer 2 is 0.3 µm or more.

6. The Ag-coated material according to any one of claims 3 to 5, wherein the Ag layer 1 has a thickness of 0.5 to 5 µm.

7. The Ag-coated material according to any one of claim 3 to 6, wherein the Ag layer 2 has a thickness of 0.5 to 5 µm.

8. The Ag-coated material according to any one of claim 3 to 7, wherein a preferential orientation plane of the Ag layer 1 is {111} plane, and a preferential orientation plane of the Ag layer 2 is {100} plane.

9. The Ag-coated material according to any one of claims 3 to 8, wherein an outermost layer of the Ag-coated material is the Ag layer 2.

10. The Ag-coated material according to any one of claims 1 to 9, wherein an underlying layer comprising Ni is provided between the base material and the Ag film.

11. The Ag-coated material according to any one of claims 1 to 10, wherein the base material comprises Cu or Cu alloy.

12. The Ag-coated material according to any one of claims 1 to 11, wherein Vickers hardness HV of the Ag-coated material is 100 or more.

13. The method for producing an Ag-coated material, including: forming an Ag film on a base material by alternately laminating at least three Ag layers with different average crystal grain sizes by three times or more.

14. The method for producing an Ag-coated material according to claim 13, wherein the Ag film is formed by laminating four or more Ag layers.

15. The method for producing an Ag-coated material according to claim 13 or 14, wherein Ag layer 1 comprising Ag with a small average crystal grain size and Ag layer 2 comprising Ag with a larger average crystal grain size than the Ag layer 1 are alternately formed on the base material.

16. The method for producing an Ag-coated material according to claim 15, wherein the Ag layer 1 has an average crystal grain size (area average grain size) of 0.2 µm or less.

17. The method for producing an Ag-coated material according to claim 15 or 16, wherein the Ag layer 2 has an average crystal grain size (area average grain size) of 0.3 µm or more.

18. The method for producing an Ag-coated material according to any one of claims 15 to 17, wherein the Ag layer 1 has a thickness of 0.5 to 5 µm.

19. The method for producing an Ag-coated material according to any one of claims 15 to 18, wherein the Ag layer 2 has a thickness of 0.5 to 5 µm.

20. The method for producing an Ag-coated material according to any one of claims 15 to 19, wherein a preferential orientation plane of the Ag layer 1 is {111} plane, and a preferential orientation plane of the Ag layer 2 is {100} plane.

21. The method for producing an Ag-coated material according to any one of claims 15 to 20, including:
forming the Ag layer 2 as an outermost layer of the Ag-coated material.

22. The method for producing an Ag-coated material according to any one of claims 15 to 21, including:
forming the Ag layer 1 by electroplating using an Ag plating solution 1 containing potassium silver cyanide, potassium cyanide, and potassium selenocyanate under conditions of a solution temperature of 10 to 35°C and a current density of 3 to 15 A/dm²,
wherein the Ag plating solution 1 is an aqueous solution containing: 80 to 130 g/L of silver,
60 to 160 g/L of potassium cyanide, and
50 to 80 mg/L of selenium.

23. The method for producing an Ag-coated material according to claim 22,
wherein 55 to 70 mg/L of the selenium is contained.

24. The method for producing an Ag-coated material according to claim 22 or 23,
wherein the electroplating is performed under a condition that a product of a concentration of potassium cyanide in the Ag plating solution 1 and a current density is 840 g·A/L·dm² or less.

25. The method for producing an Ag-coated material according to any one of claims 15 to 24, comprising:
forming the Ag layer 2 by electroplating using a silver plating solution 2 containing potassium silver cyanide, potassium cyanide, and potassium selenocyanate at a solution temperature of 10 to 40°C and a current density of 3 to 10 A/dm²,
wherein the silver plating solution 2 is an aqueous solution containing:
80 to 110 g/L of silver,
70 to 160 g/L of potassium cyanide, and
1 to 15 mg/L of selenium.

26. The method for producing an Ag-coated material according to any one of claims 13 to 25, comprising:
forming an underlying layer comprising Ni on the base material; and
forming the Ag film on the underlying layer.

27. The method for producing an Ag-coated material according to any one of claims 13 to 26,
wherein the base material comprises Cu or Cu alloy.

28. A terminal component, wherein the Ag-coated material according to any one of claims 1 to 12 is used as a constituent material.
